# EUROPEAN PATENT APPLICATION

(11) **EP 1 681 471 A2**
(43) Date of publication of application: **19.07.2006**
(21) Application number: 05028363.9
(22) Date of filing: 23.12.2005
(51) Int. Cl.: F04D 17/04, F04D 29/58

(54) **Miniature fan for high energy consuming circuit board devices**

(30) Priority: 23.12.2004 US 639052 P; 22.06.2005 US 692594 P
(71) Applicant: EVGA Corporation, Brea, CA 92821 (US)
(72) Inventor: Han, Tai-Sheng Andrew, 92835 Fullerton (US)
(74) Representative: Duhme, Torsten

(57) **Abstract**

A miniature fan including an elongated, generally tubular outer housing member adapted to receive end closure plugs or caps at each end, a miniature electric motor mounted within one of the end caps, and a generally cylindrical shaped rotor/impeller disposed within the tubular housing and extending along the length thereof between the end caps, one end thereof being coupled to the motor. The housing member is provided with openings that extend longitudinally along one side thereof to provide an entrance port, and openings that extend along another side to provide an outlet or exit port. With the exception of the motor, all other parts can be made of an injection molded plastic, metal, or a combination of plastic and metal.

## Description

### Background of the Invention

It is well known that some types of electronic circuit card or board devices consume relatively large amounts of electrical power and generate substantial amounts of thermal energy (heat) that must be removed if the device is to continue to operate as intended. For example, in modern computer products, heat dissipation is a problem that unless properly dealt with can cause the computer to malfunction or become inoperative due to overheating. This is of particular importance in the case of high performance computer devices used to rapidly process graphics and game technology. Thus, heat dissipation has become a critical issue that vendors have spent large effort to resolve, In PC units used for graphics and games, add-on units generally referred to as "graphics cards" or "VGA cards" are often installed in the computers. Such cards include a separate processor, called a GPU, one or more memory chips, and other required circuitry, all mounted to an ancillary circuit board having an edge connector that is adapted to plug into an available slot in the mother board of the principal computing device. Such cards often have extremely large computing power and, as a consequence, generate substantial heat that, if not dissipated, will adversely affect operation of the graphics card and/or PC.

Heretofore, various approaches have been tried to dissipate or otherwise remove heat from the thermal energy generating processor units and normally include some type of thermal mass capable of sinking the heat generated, as well as some type of fan for blowing air across the sink and active components.

Conventional heat dissipation heat sinks usually include a thick metal plate having a plurality of metal fins located on one side thereof to disperse the heat over a large surface area. Some sinking applications do not need additional airflow to disperse heat, and simply dissipate the energy by, in effect, increasing the radiation area of the heat generating unit. The commonly used basic heat sink is thus passive and cools by convection. However, while the simple heat sink can increase the radiation area, heat energy still has to be discharged by airflow into the surrounding area.

Means for circulating cooling air by use of a fan has been the most commonly used method for removing thermal energy from a heat source and its associated sinking device. In the usual case, outside air is taken into an apertured heat dissipation device attached to a heat source, passed through the interior of the heat dissipation device, and then discharged to the outside of the device. However, since in most applications the fan or air induction device is a simple multi-bladed rotary fan, or a short axis squirrel cage type blower, itself having a reduced thickness, cooling air does not always flow smoothly through the interior of the heat dissipation device. And since the non-smooth flow of cooling air decreases the cooling efficiency of a radiation device, heat from the thermal source cannot be effectively gathered and carrier to the outside.

It is known that cooling performance can be improved by an increase in the flow rate of cooling air. However, since this measure typically requires an increase in the size of a fan or a decrease in the cross section of the flow path, it is problematic since the overall thickness of the heat radiation device usually cannot be increased and the dimensions of the data processing apparatus cannot be decreased. Furthermore, from a practical standpoint, space for accommodating a larger fan is not available in a thin heat radiation device, and the thickness of the data processing apparatus cannot be reduced.

There is thus a need for a new type of fan or blower that can be readily attached to a card or heat sink without requiring extra flow directing means for interfacing the fan effluent to the heat sink or device to be cooled.

High performance notebook computers are extremely compact devices that require high performance central processing units (CPUs), and as do the graphics processors, such high performance electronic components also generate a significant amount of heat during operation. Unless removed, such heat also degrades the processing speed and/or performance of the device. For this reason, high temperature, heat generating CPUs are normally provided with some type of cooling means designed in response to the temperature generated by the component. SpeciFically, when the heat generating unit generates low heat, it can simply be air-cooled using a heat sink or a heat pipe. But when the heat generating unit generates a significant amount of heat, it must be forcibly cooled using a fan, or perhaps both an active cooler, such as a Peltier device, and a fan. For example, in today's high performance notebook PCs, it is very difficult to simply air-cool a CPU that generates a large amount of heat. Accordingly, almost all high-performance notebook PCs are forcibly cooled using an active cooling system including a fan and a custom engineered heat sink assembly

However, as laptop computers and other consumer, commercial, and military electronics, are continuously reduced in size, the space available for mounting a conventional multi-blade fan or squirrel cage type blower is also reduced. There is thus a need for a smaller and improved air moving mechanism, which can be added to a standard graphics card to efficiently remove thermal energy generated thereby.

### Summary of the Invention

It is therefore an object of the present invention to provide an improved air moving mechanism that has a platform more suitable than conventional fans for use in association with electronic circuit board devices.

Another object of the present invention is to provide a mechanism of the type described that is particularly suited for attachment to a side edge of a circuit card to introduce a flow of air across or extract a flow of air from the card and/or associated heat sinks attached thereto.

Still another object of the present invention is to provide a mechanism of the type described that is simple in structure and can be mass produced in large quantity at relatively low cost.

Yet another object of the present invention is to provide a mechanism of the type described having a small number of constituent parts most of which can be injection molded and snap fit together.

A still further object of the present invention is to provide an elongated mechanism of small transverse cross section that can be configured in different lengths and dimensions to suit particular applications.

Briefly, a presently preferred embodiment of the present invention includes an elongated generally tubular outer housing member adapted to receive end closure plugs or caps, a miniature electric motor mounted within one of the end caps, a bearing means formed in the other end cap, and a generally cylindrically shaped impeller disposed within the tubular housing and extending along the length thereof between the motor at one end and a bearing means at the other end. The housing member is provided with openings that extend longitudinally along one side thereof to provide an entrance or inlet port, and openings that extend along another side to provide an exit or outlet port. The impeller includes an elongated rotor terminating at one end in a coupling for mating with the motor, and terminating at the opposite end in a means for engaging the bearing means formed in the other end cap. Integrally associated with the rotor are elongated and generally radially extending vanes the outer extremities of which extend in close proximity to the inside surface of the housing. In operation, the motor causes the impeller to rotate about its longitudinal axis such that its vanes sweep air from the entrance port(s), carry it along at least one interior wall of the housing, and then expel it out through the outlet port(s). All parts can be made of a plastic, metal, ceramics or a combination of plastic, metal, ceramics or a combination thereof.

An important advantage of the present invention is that it can be made to have any suitable longitudinal length and set of transverse dimensions.

Another advantage of the present invention is that it can be made to include any of a broad spectrum of motor powers by simply extending the length of the motor

Similarly, the present invention can be made to include any of a broad spectrum of flow volumes by simply changing the cross sectional dimensions or extending the length of the housing and the impeller.

These and other advantages of the present invention will become apparent to those skilled in the art after a reading of the following detailed description of the preferred embodiments shown in the several figures of the drawing wherein:

### In the Drawing

Fig. 1 is a perspective view illustrating a miniature fan in accordance with the present invention affixed to one side of a flow directing heat sink mounted to a graphics card assembly or the like;

Fig. 2 is an enlarged perspective view more clearly illustrating the exterior details of the miniature fan of Fig. 1 showing the inlet opening side thereof;

Fig. 3 is an enlarged perspective view more clearly illustrating the exterior details of the miniature fan of Fig. 1 showing the outlet opening side thereof;

Fig. 4 is an exploded perspective view illustrating the principal component parts of the miniature fan of Fig. 1, the main housing member part thereof being broken to show the inlet opening in the remote side thereof;

Fig. 5 is a perspective view showing the housing member and end caps broken along a plane passing through the longitudinal axis of the impeller to illustrate certain interior details of the miniature fan of Fig. 1; and

Fig. 6 is a stylized transverse sectional view schematically showing the air flow characteristics of the miniature fan of Fig. 1.

### Detailed Description of a Preferred Embodiment

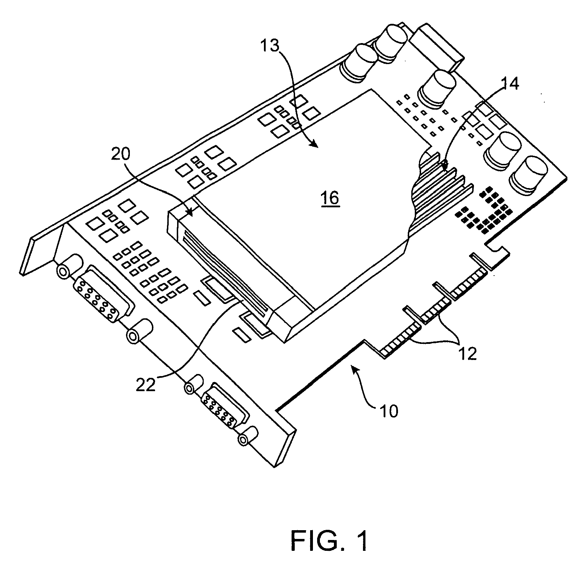

Referring now to Fig. 1 of the drawing there is shown at 10 a typical example of a graphics card of the type that might be installed in a PC by inserting the edge connectors 12 into an available slot on the motherboard (not shown). Shown mounted to the top of the card 10 is a heat sink assembly 13 that might include a metal bottom plate having a plurality of upstanding ribs formed integral therewith as depicted at 14. Affixed to the top of the ribs is a metal upper plate 16 having its lower right corner broken away to reveal the ribbed lower part 14. Note that the bottom and top plates are separated by the ribs and that the ribs are disposed in a parallel array to define a plurality of air flow passageways extending along the heat sink from left to right as depicted.

Affixed to the foreground edge of heat sink 13 is an embodiment of a fan or blower device 20 in accordance with the present invention. The device 20 is generally in the form of an elongated right rectangular structure having its long dimension extending along the leftmost or foreground edge of card 13. Fan 20 is affixed to card 13 by any suitable means, such as tabs and screws or bolts (not shown), an adhesive, or tack welds. A single, pair or other plurality of inlet slots 22 is/are provided on the front side face of the device. Air is drawn in through these slots for expulsion through one or more exit slots (not shown) on the back side thereof for introduction by the fan into the heat sink 13.

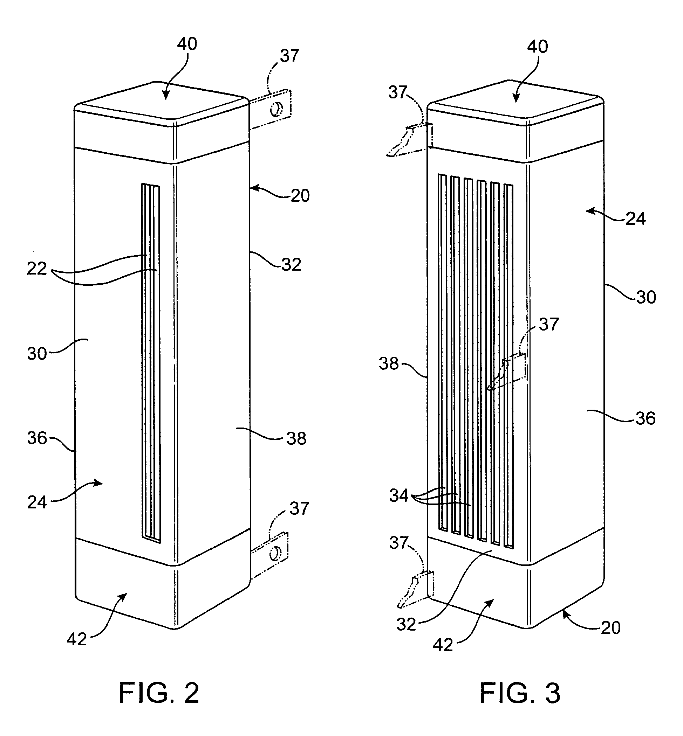

The exterior construction of the fan 20 is shown in enlarged detail in Figs. 2 and 3 wherein the front face including the air flow inlet slots 22 is depicted in Fig. 2, and the rear face, including the plurality of air flow outlet slots 34, is depicted in Fig. 3. As shown in these figures, the exterior housing of fan 20 is formed by a generally tubular housing member 24 having a rectangular (square) transverse cross section defined by a first pair of parallel opposing front and rear walls 30 and 32, and a second pair of opposing parallel side walls 36 and 38. The otherwise open ends of the tubular housing member 24 are closed by a pair of end caps 40 and 42 to form a rotor receiving internal chamber (not shown). Alternatively, the cross section could be formed in other geometric shapes including oval or partially oval, or of any other suitable transverse sectional configuration capable of cooperating with an impeller and inlet and outlet openings to form a blower device. The device can be made in almost any desired size and length. For example, in one small size embodiment, the device has external dimensions of 1.2 x 1.2 x 5 centimeters.

As will be further explained below, the inlet slot or slots 22 are arrayed or positioned on one side of the front wall 30 to extend across substantially the entire longitudinal length of the housing member 24, while the outlet slot or slots 34 are arrayed or positioned on the opposite side of the housing member 24 and occupy a larger area of the rear face 32. Preferably, the inlet openings or slots 22 are disposed on one side of a plane (not shown) intersecting the housing 24 normal to front wall 30, and passing through the longitudinal axis of the device. The outlet openings or slots 34 are symmetrically positioned on both sides of the same plane as it extends through and out of the opposite side of the device. In this embodiment, the end caps 40 and 42 are of slightly different size, with the cap 40 serving as a bearing support member, and the cap 42 serving as a drive motor housing as well as bearing support. Suitable flanges, tabs or other means such as those suggested by the dashed lines 37 in Figs. 2 and 3, may be provided for fastening the fan device to a PC board, heat sink or other supporting structure. Such fastening means may be affixed to or molded integral with the tubular housing 24 and/or the end caps 40, 42. Alternatively, the fan could be attached to a supporting structure by one or more straps (not shown).

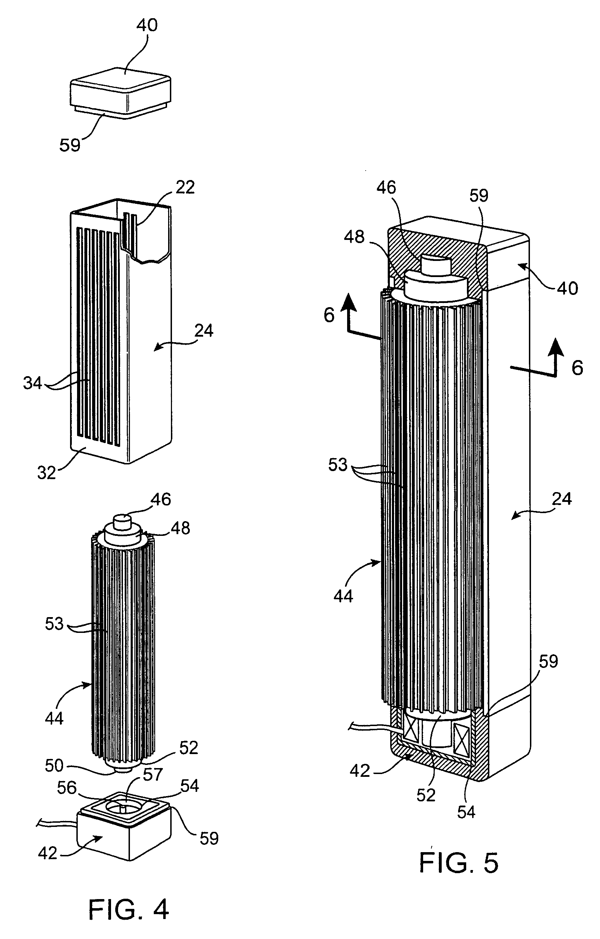

Turning now to Fig. 4, the fan device is shown with the end caps 40 and 42 exploded axially outwardly from their mating engagement with the tubular housing 24. Also shown removed axially from the tubular housing 24 is an impeller or rotor 44 having a supporting shaft extending axially from each end at 46 and 50. A suitable annular bearing member 48 is coaxially disposed on the upper end 46 as depicted. A similar bearing member 52 is provided on shaft end 50 at the opposite end of rotor 44. Although not shown in this figure, the end cap 40 includes a receptacle for receiving the bearing 48 and shaft end 46 such that the end 46 of rotor 44 is journalled to end cap 40.

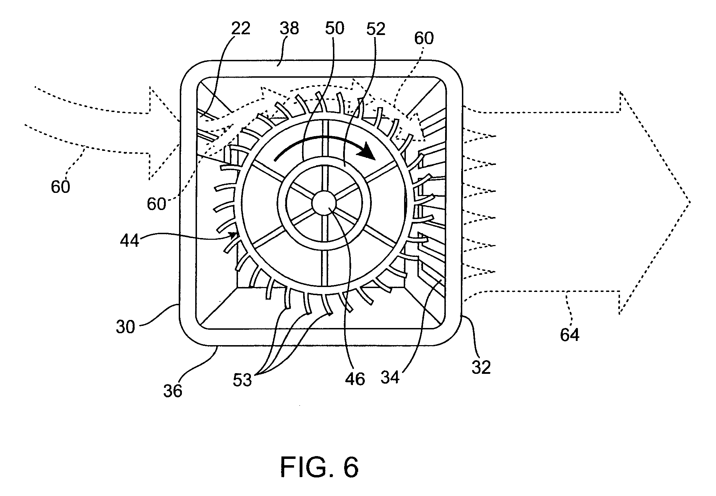

As depicted in this figure, the rotor 44 is formed of an elongated, solid or hollow, cylindrically shaped body having a plurality of elongated vanes 53 extending along the length thereof. The vanes 53 may be parallel and continuous or segmented along the length of the rotor, and may be straight, helical or serpentine relative to the axis of the rotor. Furthermore, the planes of the vanes may extend radially, at an angle to radial (as depicted in Fig. 6), be segmented and cup-shaped, or have any other suitable configuration designed to move fluid from the entrance side of the housing to the other side for exit.

At the bottom of Fig. 4, the lower end cap 42 is shown to include a receptacle 57 for receiving the bearing 52 and shaft end 50 such that the end 50 of rotor 44 is journalled to end cap 42. End cap 42 also has a pocket in which a small electric motor 54 is nested. The motor may be AC or DC, but is typically a DC motor operated at a voltage of between 4-24 volts conveniently available from a computer power supply. Motor 54 is provided with a drive shaft 56 having a square shaped, hex-shaped or other suitable cross section that can be mating engaged within a similarly configured female socket 56 (Fig. 6) formed in the end of shaft 50 so as to provide direct drive to rotor 44.

The four parts shown separate in Fig. 4 are assembled by collapsing the several components axially, with rotor 44 moving downwardly to engage the bearing 52 and motor 54, and housing 24 slipping over rotor 44 so that its lower end engages and seats within the shoulder 59 in lower cap 42. The assembly is completed by mating the shaft end 46 and bearing 48 with the corresponding receptacles (not shown) formed in the lower side of end cap 40, and seating the upper end of housing 44 in the shoulder 59 formed around the lower perimeter of the upper end cap 40. The caps 40 and 42 may be designed to snap fittingly engage the ends of member 24 or they may be retained by the use of glue or epoxy or the like. The assembled engagement is shown in Fig. 5, wherein the housing 24, end caps 40 and 42, and motor 54 are, for clarity, shown split along the longitudinal axis of the fan to illustrate the assembled configuration of the several previously described component parts.

Fig. 6 is a stylized, transverse sectional view taken in the plane 6-6 of Fig. 5 and shows how the vanes 53 "drag" or "draw" ambient air (represented by the dashed lines 60) in through inlet slots 22, "carry" it across the lovaer portion of the housing 24 (as suggested by the dashed lines 62), and then centrifugally "throw" it out through the outlet slots 34 (as suggested by the dashed lines 64). It is believed that with the rotor rotating about its longitudinal axis, the vanes 53 in effect scoop the ambient air at the low pressure inlet slots 22 and cause it to move with the rotor around the inside of the housing. As the moving air experiences centrifugal acceleration tangentially and radially outwardly relative to the axis of rotation of the rotor, it also experiences an increase in pressure and momentum that causes it to exit the housing via the outlet slots 34. As a consequence, the device acts to draw air into one side thereof and blow it out the other side thereby functioning as a fan.

As suggested above, with the exception of the motor 54, all of the several device components can be made using small, structurally simple, injection molded metal, plastic or ceramic parts that can be snap-fit or glued together during assembly to form elongated fluid pumping devices of various sizes having substantial utility for the particular application described above as well as other applications having similar requirements. Furthermore, whereas the "pumping" efficiency of the fan device could perhaps be improved by "streamlining" the interior walls of the housing 30 to eliminate corners and enhance laminar flow within the housing, such streamlining is not deemed necessary to provide a device capable of creating an air flow useful for the suggested applications.

Although the present invention has been described above in terms of a single preferred embodiment, it is understood that various modifications in size, relative dimensions, inlet and outlet configurations, rotor vane configuration, construction methods and materials, etc., will no doubt become apparent to those skilled in the art after having read this disclosure. Accordingly, it is intended that the above disclosure be interpreted as exemplary rather than limiting, and that the appended claims be interpreted broadly, and limited only by the true spirit and scope of the invention.

Thus, it is proposed a miniature fan including an elongated, generally tubular outer housing member adapted to receive end closure plugs or caps at each end, a miniature electric motor mounted within one of the end caps, and a generally cylindrical shaped rotor/impeller disposed within the tubular housing and extending along the length thereof between the end caps, one end thereof being coupled to the motor. The housing member is provided with openings that extend longitudinally along one side thereof to provide an entrance port, and openings that extend along another side to provide an outlet or exit port. With the exception of the motor, all other parts can be made of an injection molded plastic, metal, or a combination of plastic and metal.

## Claims

1. A fan comprising:
an elongated housing open along its length and forming a rotor receiving chamber, said housing having one or more inlet openings formed in one side thereof and one or more outlet openings formed in another side thereof;
an elongated rotor disposed within said chamber, rotatable about a longitudinal axis thereof, and having a plurality of impeller components disposed along its length; and
a motor disposed at said one end of said chamber and adapted to cause said rotor to rotate about said longitudinal axis whereby ambient fluid is drawn into said chamber by said impeller components and expelled therefrom through said outlet openings.

2. A fan as recited in claim 1 wherein said inlet openings are formed in a first wall of said housing, and said outlet openings are formed in a second wall of said housing, said first and second walls lying on opposite sides of said longitudinal axis.

3. A fan as recited in claim 1 or 2 wherein said inlet openings are formed in said first wall of said housing on one side of a first plane normal to said first wall and passing through said longitudinal axis, and wherein said outlet openings are formed in said second wall of said housing and symmetrical about said first plane.

4. A fan as recited in claim 1, 2 or 3 and further comprising:
a first end cap closing one end of said chamber; and
a second end cap closing an opposite end thereof;
wherein one end of said rotor is journalled to said first end cap, and the opposite end of said rotor is journalled to said second end cap.

5. A fan as recited in any of claims 1 to 4 wherein said elongated housing and said end caps form a right rectangular object of length L, width W and depth D, where W is a dimension substantially equal to D, and L is a dimension substantially larger than the dimensions W and D, preferably L is at least twice as long as the longer of W and D.

6. A fan as recited in any of claims 1 to 5 wherein said rotor is generally cylindrical in shape and has means forming impeller vanes longitudinally extending along its outer cylindrical surface.

7. A miniature fluid moving fan for use in association with a heat sink or the like, comprising:
an elongated housing forming a rotor receiving chamber, said housing having an inlet port formed in one side thereof and an outlet port formed in another side thereof;
an elongated rotor disposed within said chamber and rotatable about a longitudinal axis thereof, said rotor having a plurality of impeller components extending along its length, and
a motor disposed at one end of said chamber and adapted to cause said rotor to rotate about said longitudinal axis, to draw ambient fluid through said inlet port into said chamber and to expel the drawn in ambient fluid from said chamber through said outlet port.

8. A miniature fluid moving fan as recited in any of claims 1 to 7 wherein said inlet port includes one or more inlet openings formed in a first wall of said housing, and said outlet port includes one or more outlet openings formed in a second wall of said housing, said first and second walls lying on opposite sides of said longitudinal axis.

9. A miniature fluid moving fan as recited in any of claims 1 to 8 wherein said inlet openings are formed in said first wall of said housing on only one side of a plane passing through said longitudinal axis, and wherein said outlet openings are formed in said second wall of said housing and are disposed symmetrical about said first plane.

10. A miniature fluid moving fan as recited in any of claims 1 to 9 wherein one end of said rotor is journalled to a first end cap forming a closure for one end of said chamber, and the opposite end of said rotor is journalled to a second end cap forming a closure for a second end of said chamber.

11. A miniature fluid moving fan as recited in any of claims 1 to 10 wherein said elongated housing is of length L', and diameter D', where L' is a dimension substantially larger than the dimension D', preferably more than twice as large, and more preferred more than three times as large.

12. A miniature fluid moving fan as recited in any of claims 1 to 11 wherein said rotor is generally cylindrical in shape and said impeller components are in the form of vanes radially extending therefrom along its outer cylindrical surface.

13. A means for removing heat from electronic components, comprising:
a heat sink for attachment to an electronic component and including means for directing a stream of heat removing fluid over at least one surface thereof; and
a fan for attachment to said heat sink and for generating said stream of heat removing fluid, said fan including
an elongated housing open along its length and at both ends to form a rotor receiving chamber, said housing having an inlet port formed in one side thereof and an outlet port formed in another side thereof;
an elongated rotor disposed within said chamber and rotatable about a longitudinal axis thereof, said rotor having a plurality of impeller components extending along its length,
a first end cap affixed to said housing and closing one end of said chamber, and a second end cap affixed to said housing and closing an opposite end thereof;
a motor disposed at said one end of said chamber and adapted to cause said rotor to rotate about said longitudinal axis whereby ambient fluid is drawn through said inlet port into said chamber by said impeller components and expelled therefrom through said outlet port; and
means for mounting said fan to said heat sink.

14. A fan as recited in any of claims 1 to 13 wherein said inlet openings are formed in said first wall of said housing on one side of a first plane normal to said first wall and passing through said longitudinal axis, and wherein said outlet openings are formed in said second wall of said housing on both sides of said first plane.

15. A fan as recited in any of claims 1 to 14 wherein said inlet openings are formed in said first wall of said housing on only one side of a plane normal to said first wall and passing through said longitudinal axis, and wherein said outlet openings are formed in said second wall of said housing symmetrical about said first plane.
